# EUROPEAN PATENT APPLICATION

(11) **EP 4 181 642 A1**
(43) Date of publication of application: **17.05.2023**
(21) Application number: 21208623.5
(22) Date of filing: 16.11.2021
(51) Int. Cl.: H05K 7/20

(54) **COOLING SYSTEM FOR ELECTRONIC COMPONENT RACKS**

(71) Applicant: JJ Cooling Innovation Sàrl, 1018 Lausanne (CH)
(72) Inventor: Thome, John R., 1009 Pully (CH); Marcinichen, Jackson B., 1018 Lausanne (CH)
(74) Representative: reuteler & cie SA

(57) **Abstract**

Cooling system for a multi-unit electronic apparatus stack (1) comprising a plurality of stacked electronic units (3), the cooling system comprising a plurality of unit cooling systems (6) incorporated in, on or between each electronic unit, each unit cooling system (6) comprising one or more fluid flow circuits (13) configured as:
- a pulsating heat pipe (PHP) including a pipe (34) having one or more channels (36) therein containing a coolant fluid, the pipe (34) extending between a condenser end (16) and an evaporator end (15), or
- a thermosyphon (LTS) cooling system comprising pipes (14a, 14b) extending between a condenser end (16) and an evaporator end (15);
the cooling system (2) further comprising a stack cooling system (4) comprising a principal condenser (12) and a fluid flow circuit (8) including a downcomer (8a) and a riser (8b) configured as a loop thermosyphon (LTS) cooling system, the riser comprising a riser pipe (24) extending vertically across a plurality of stacked electronic units (3), each of the unit cooling systems (6) comprising a thermal interface coupling (16) thermally coupled to the riser pipe (24), the fluid flow circuits (13) of the unit cooling systems being independent from the fluid flow circuit (8) of the stack cooling system (4).

## Description

The present invention relates to a system for cooling electronic units in a multi-unit rack. In particular the present invention is directed to the cooling of computer servers. The field of the invention however extends more generally to the cooling of electronic units of other types that are stacked.

High power datacenter servers, power electronics modules and telecom data transmission equipment are commonly installed in electronics racks with a requirement of high density of heat dissipation per unit volume in the rack. Thus, these racks need to be effectively and efficiently cooled to thermally manage the operating temperatures of the installed electronics to stay within their allowable working range. The technical challenge is to remove a large quantity of heat from a confined/compact volume using as little energy to drive the cooling system as possible.

Current cooling technologies are available principally in four forms: (i) air-cooling with fans blowing air over heat sinks with or without embedded heat pipes, (ii) water-cooling with pump(s) driving the water through heat sinks, (iii) immersion cooling in which the entire rack is emerged in a liquid cooled bath of dielectric liquid, and (iv) individual thermosyphon heat sinks cooled by air with fans placed in each server.

Air-cooling is an expensive electrical energy consumer and cannot handle the very high heat densities of the new powerful electronics as the air flow rate and fan noise become prohibitive. Water-cooling is a high risk if any leak or drip occurs into the electronics during operation or servicing. Immersion cooling requires twice as much floor space to install the tall rack horizontally and creates additional maintenance issues. Individual air-cooled thermosyphons, which are a mini-thermosyphon for each individual electronic component cooled by air flow within the server, extend the range of air-cooling to higher heat loads than (i) but do not handle the high heat loads in 1U servers (1.75 inch or 44.4 mm height) commonly used in densely packed racks and in any case still have the air flow rate and fan noise problems.

Cooling stacked computer servers with thermosyphons are described for instance in US 20190107333, US 20200015387, US 20200113083, and WO 2007102978. The advantage of thermosyphons is their ability to transfer large amounts of heat in a compact configuration compared to air-cooled systems. However, in conventional systems, the coupling of the computer servers to the thermosyphon network renders the system complex and configurations with different numbers of servers or the replacement of individual units is time consuming and laborious.

In view of the foregoing, it is an object of the invention to provide a cooling system for a multi-unit stack of electronic devices that is compact with a high heat transfer capability, yet that is economical to manufacture, configure and install.

It is advantageous to provide a cooling system for a multi-unit electronic apparatus that allows easy and economical replacement of electronic units.

It is advantageous to provide a cooling system for a multi-unit electronic apparatus that is reliable and can be easily and economically adapted for different numbers of electronic units.

It is advantageous to provide a cooling system for a multi-unit electronic apparatus that can be easily and economically integrated into existing electronic units.

Objects of the invention have been achieved by providing a cooling system according to claim 1.

Dependent claims set out various advantageous features of embodiments of the invention.

Disclosed herein is a cooling system for a multi-unit electronic apparatus stack comprising a plurality of stacked electronic units. The cooling system comprises a plurality of unit cooling systems incorporated in, on or between each electronic unit, each unit cooling system comprising one or more fluid flow circuits configured as:
- a pulsating heat pipe (PHP) including a pipe having one or more channels therein containing a coolant fluid, the pipe extending between a condenser end and an evaporator end, or
- a thermosyphon (LTS) cooling system comprising pipes extending between a condenser end and an evaporator end.

The cooling system further comprises a stack cooling system comprising a principal condenser and a fluid flow circuit including a downcomer and a riser configured as a loop thermosyphon (LTS) cooling system. The riser comprises a riser pipe extending vertically across a plurality of stacked electronic units, each of the unit cooling systems comprising a thermal interface coupling thermally coupled to the riser pipe. The fluid flow circuits of the unit cooling systems are independent from the fluid flow circuit of the stack cooling system.

The riser and downcomer may be placed at any convenient position along any side or at any corner of the multi-unit electronic apparatus stack to allow easy access to the electronic units.

The fluid flow circuits of the unit cooling systems are independent from the fluid flow circuit of the stack cooling system.

In an advantageous embodiment, the riser pipe comprises a substantially rectangular cross-section.

In an advantageous embodiment, the riser pipe cross-section has a length L to width *W* ratio *L*/*W* in a range of 30/1 to 3/1. The cross-sectional dimensions of the riser pipe may be constant or may vary along the height of the stack. For instance, to take into account the increase in volume as coolant changes phase from liquid to gas, the riser pipe may be provided with a greater cross-sectional area at the upper part compared to the lower part thereof. The increase may be stepwise and/or continuous.

In an advantageous embodiment, the riser pipe has substantially flat opposed surfaces and the thermal interface coupling comprises a flat surface for clamping against the flat surface of the riser pipe.

In variants, the riser pipe may have circular, polygonal or irregular shaped cross-sectional profiles, provided that the shape of the thermal interface coupling of the unit cooling systems is adapted thereto to ensure sufficient thermal coupling to the riser pipe.

In an advantageous embodiment, the pipe of the unit cooling system comprises a plurality of channels.

In an advantageous embodiment, the plurality of channels are arranged in a serpentine shape to form a pulsating heat pipe (PHP).

In an advantageous embodiment, the pipe of the unit cooling system comprises an evaporator end thermal interface coupling having a major surface for thermally coupling against a heat generating electronic component of the electronic unit.

In an advantageous embodiment, the pipe of the unit cooling system comprises a condenser end thermal interface coupling having a major surface for thermally coupling against a heat absorbing component of the rack cooling system.

In an advantageous embodiment, the pipe of the unit cooling system is formed of an extruded metal piece, for instance an extruded aluminum piece.

In an advantageous embodiment, the downcomer of the stack cooling system comprises a single channel pipe.

In an embodiment, the downcomer pipe may include a liquid accumulator.

In an advantageous embodiment, the principal condenser is arranged above the top of the multi-unit electronic apparatus stack.

In an advantageous embodiment, the principal condenser comprises an air-liquid heat exchanger.

In an advantageous embodiment, the principal condenser further comprises a liquid-liquid heat exchanger including channels for flow of the coolant of the stack cooling system and channels separate therefrom for flow of cooling liquid from the air-liquid heat exchanger.

In an advantageous embodiment, the channels include alternating layers of separate micro-cooling channels, the micro-cooling channels of each layer arranged in a single header for each fluid flow with respective inlet and outlet connecting openings.

In an advantageous embodiment, the riser pipe extends substantially vertically across a plurality of electronic units configured to allow clamping of plate shaped thermal interface couplings of the unit cooling system at any position along the riser pipe.

Further advantageous features of the invention will be apparent from the following detailed description of embodiments of the invention and the accompanying illustrations.

### Brief description of the figures

Figure 1a is a schematic representation of a conventional loop thermosyphon (LTS) passive two-phase cooling system;
Figure 1b is a schematic representation of a conventional two-phase closed loop pulsating heat pipe (PHP) cooling system;
Figure 1c is a schematic representation of a conventional open loop two-phase pulsating heat pipe (PHP) cooling system;
Figure 2 is a simplified schematic representation of a multi-unit electronic apparatus stack, for instance a stack of computer servers, and associated cooling systems according to an embodiment of the invention;
Figure 2a is a simplified schematic representation of the fluid flow circuit of a loop thermosyphon unit cooling system for a single electronic unit, for instance a server with two microprocessors;
Figure 2b is a schematic representation similar to figure 2a however showing a possible configuration of a pulsating heat pipe unit cooling system according to an embodiment of the invention, for instance a server with two microprocessors;
Figure 3 is a schematic representation of a plurality of multi-unit electronic apparatus stacks and associated cooling systems according to an embodiment of the invention;
Figure 4a is a schematic perspective view of a thermal interface coupling between a thermosyphon unit cooling system and a riser pipe of the stack cooling system according to an embodiment of the invention;
Figure 4b is a view similar to figure 4a of a variant with a pulsating heat pipe unit cooling system;
Figure 5 is a schematic cross-sectional view through a riser pipe of a fluid flow circuit of the stack cooling system, for instance of the riser pipe of figures 4a and 4b, according to an embodiment of the invention;
Figure 6 is a perspective view of a multi-channel pipe of a fluid flow circuit forming a pulsating heat pipe unit cooling system according to an embodiment of the invention;
Figure 6a and 6b show cross-sectional views of ends of the multi-channel pipe of figure 6;
Figure 7 is a cross-sectional view of a liquid-liquid heat exchanger of a stack cooling system, according to an embodiment of the invention;
Figures 8a and 8b are perspective views of air-liquid heat exchanger of a stack cooling system according to embodiments of the invention.

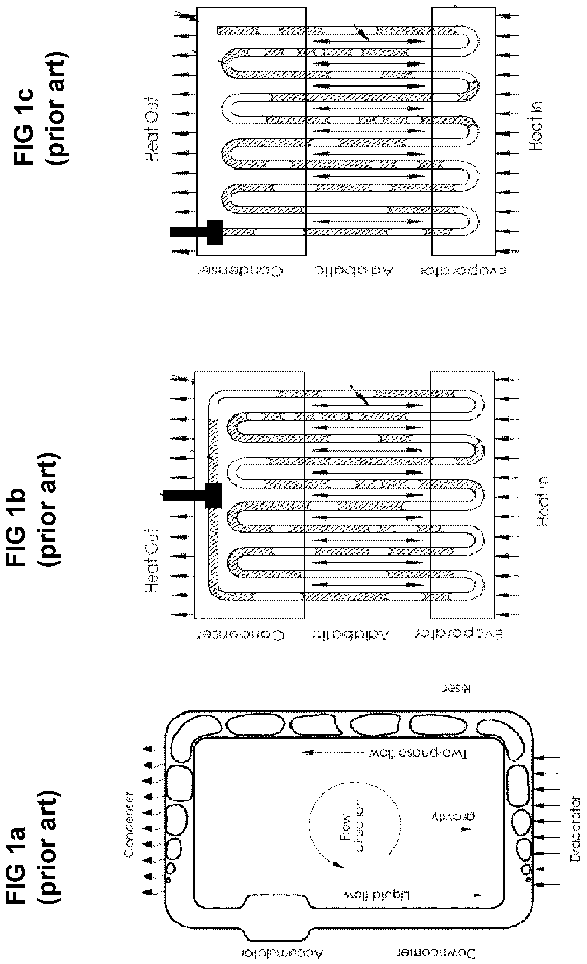

The generic conceptual channel layout and fluid flow within a *per se* known loop thermosyphon and pulsating heat pipe are shown in figure 1a (LTS), figure 1b (closed loop PHP) and figure 1c (open loop PHP).

Basically, a LTS has a gravity-driven internal coolant flow. The coolant is partially evaporated in the Evaporator removing the heat from the electronics and flows up the Riser due to buoyancy. The flow passes through the Condenser where the heat is removed to the secondary coolant (air, liquid or another two-phase flow) converting the vapor back to liquid, and finally gravity pulls the liquid down the Downcomer where the coolant reenters the Evaporator to continue the flow around the loop. It is also sometimes useful to include a liquid accumulator in the LTS loop at the exit of the condenser to manage the liquid inventory in the LTS over a wide range of operating conditions, as shown, but it is not always needed and can be removed from the loop.

A pulsating heat pipe, also known as an oscillating heat pipe, is a closed or open serpentine loop in which a fraction of the internal volume of the serpentine is filled by the liquid coolant and the remaining internal volume is filled by its vapor. The coolant boils at the evaporator end and condenses at the condenser end while the flow inside is created by instabilities from the creation and collapse of the vapor bubbles, making the flow passively oscillate from one direction to the opposite direction inside the serpentine.

All of these systems, LTS and PHP, include a filling or charging port to evacuate the loop or serpentine and to put the coolant inside them.

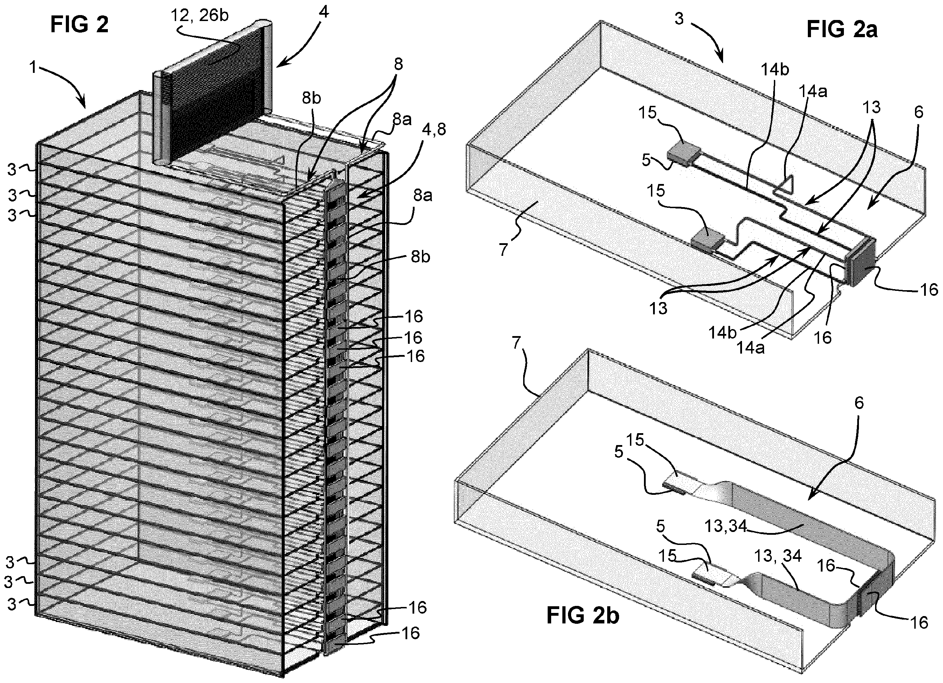

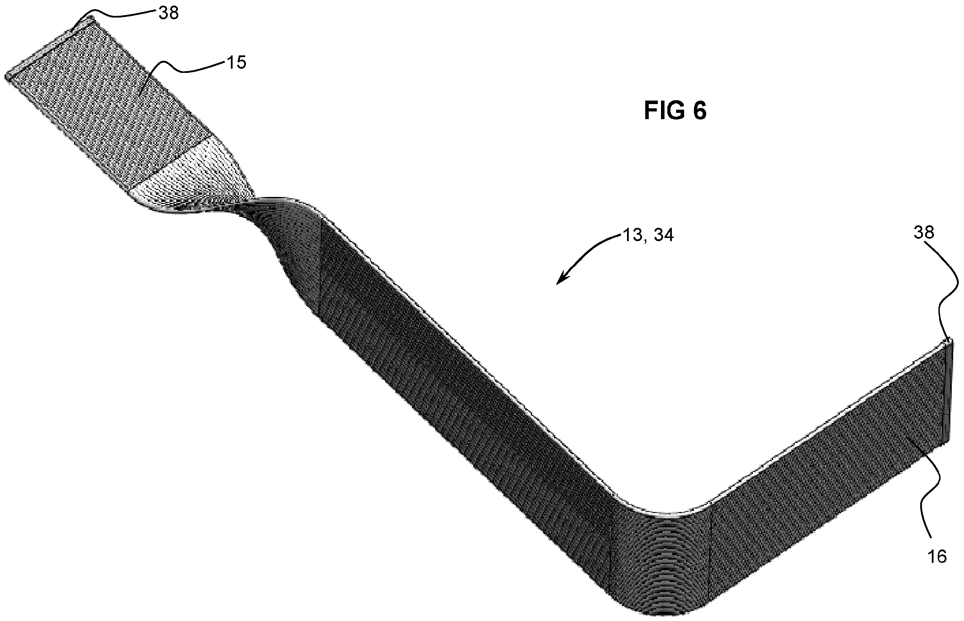

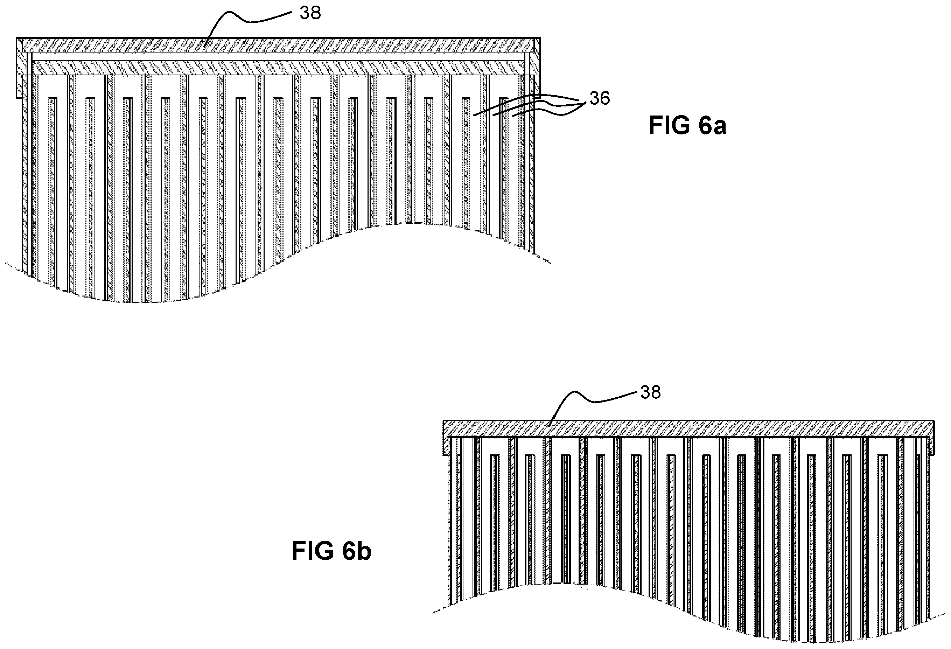

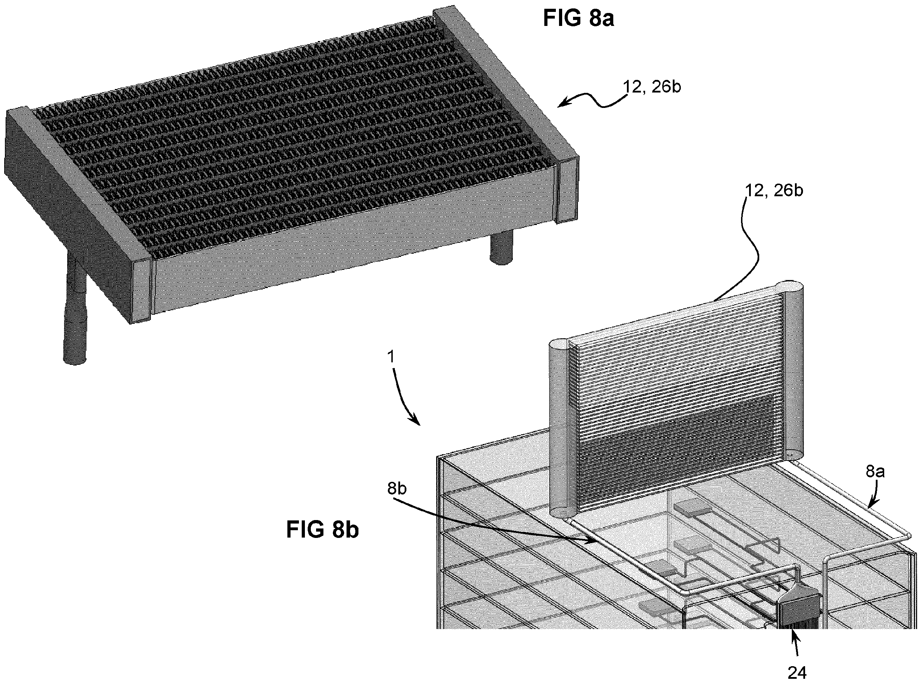

Referring to the figures 2-8b, embodiments of the invention are illustrated. A multi-unit electronic apparatus stack 1 comprises a plurality of electronic units 3 grouped together, for instance arranged in at least one vertical stack. It may be noted that the multi-unit electronic apparatus stack may comprise a plurality of vertical stacks; however, for the purposes of illustrating embodiments of the invention, a single stack is illustrated and shall be described herein.

In a typical application of the invention, the electronic units may consist of computer servers, for instance computer servers of a data center. The invention however may be employed with other types of electronic units that are stacked together and require cooling.

A cooling system 2 according to embodiments of the invention is integrated with the multi-unit electronic apparatus stack.

The cooling system 2 comprises a large or principal cooling system 4 that we shall refer to herein as the stack cooling system 4, and a plurality of unit cooling systems 6 that are thermally coupled to the stack cooling system 4. The unit cooling systems 6 are incorporated in each electronic unit 3 or may be provided for a group of electronic units 3 that form a portion of the multi-unit electronic apparatus stack 1.

In the embodiments illustrated, the unit cooling system 6 comprises cooling fluid flow circuits 13, that are mounted within the housings 7 of each electronic unit, however in variants (not illustrated) the unit cooling system could be mounted as part of the housing 7 or on the outside of the electronic units 3, for instance at interfaces between two electronic units 3. In the latter case, heat sinks and heat conductive materials may bridge the heat producing electronic components 5 (for instance processors) to the housing 7 coupled to the unit cooling system.

The stack cooling system 4 comprises a principal condenser 12 and a cooling fluid flow circuit 8 configured as a thermosyphon cooling circuit. The fluid flow circuit 8 comprises a downcomer 8a and a riser 8b. The principal condenser 12 serves to cool the coolant flowing in the fluid flow circuit 8 and is preferably arranged at the top of the stack cooling system 4.

The principal condenser 12 comprises at least one heat exchanger, for instance an air-liquid heat exchanger 26b, and/or a liquid-liquid heat exchanger 26a coupled to an air-liquid heat exchanger 26b, that may be positioned above the multi-unit apparatus stack 1. The air-liquid heat exchanger 26b may be positioned at a certain distance from the stack 1 and may either be cooled by indoor air, or by environmental air (outside air), passively by natural convection, or by forced convection using fans 32, or various such heat exchanger systems being *per se* well known and do not need to be described further herein.

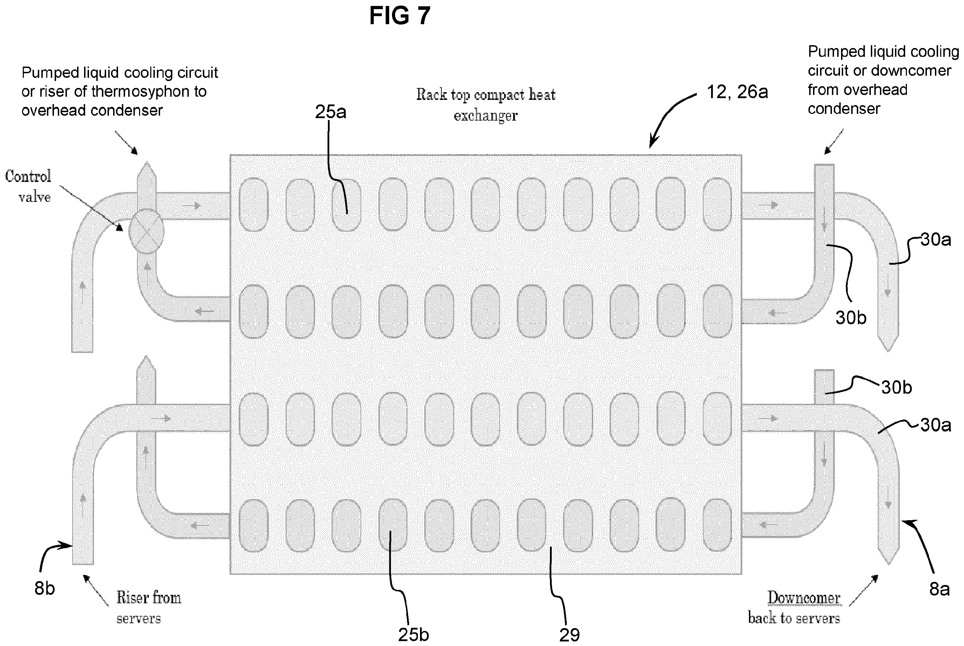

The heat exchanger may advantageously comprise a first liquid-liquid heat exchanger 26a, for instance as illustrated in figure 7, comprising a liquid-liquid heat exchanger block 29 having a hot liquid circuit 30a, that may for instance have a serpentine channel 25a, connected to the stack cooling system fluid flow circuit 8, and a cool liquid circuit 30b, that may for instance also have a serpentine channel 25b, connected to a liquid circuit 33 of a second heat exchanger, for instance a liquid-air heat exchanger 26b.

In a variant, the principal condenser 12 may comprise only an air-liquid heat exchanger 26b, the liquid circuit thereof being connected to the riser and downcomer of the stack cooling system.

The principal condenser 12 thus receives the coolant fluid flowing in from the riser 8b and outputs the coolant fluid into the downcomer 8a that is cooled by the one or more heat exchangers 26a, 26b.

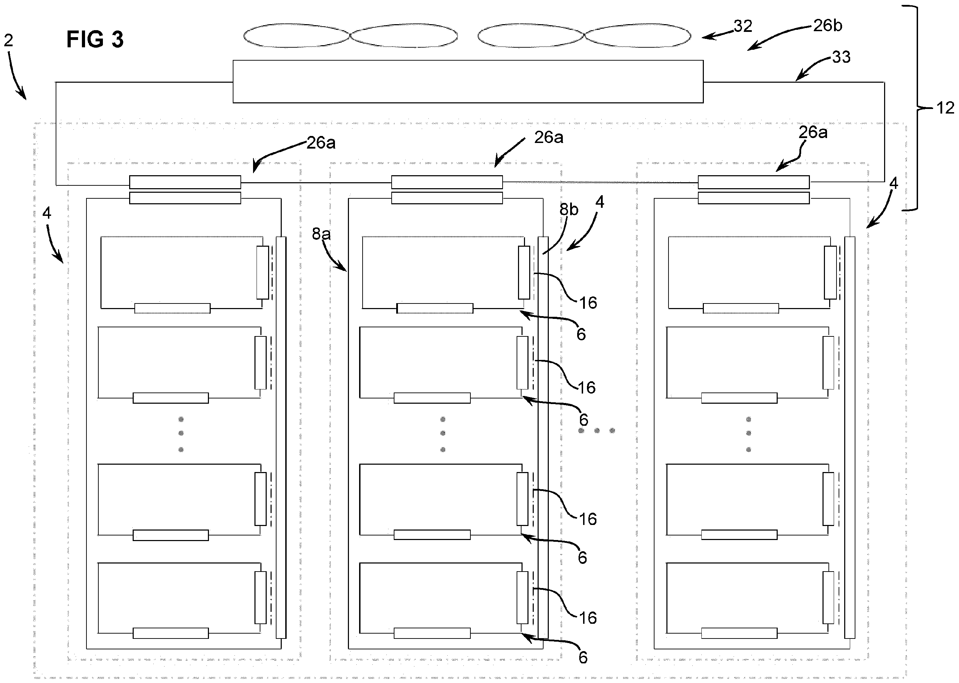

The air-liquid heat exchanger 26b, in the embodiments where it is implemented, may receive gravity-driven thermosyphon coolant rising from and returning to one or more liquid-liquid heat exchangers 26a, for instance as illustrated in figure 3.

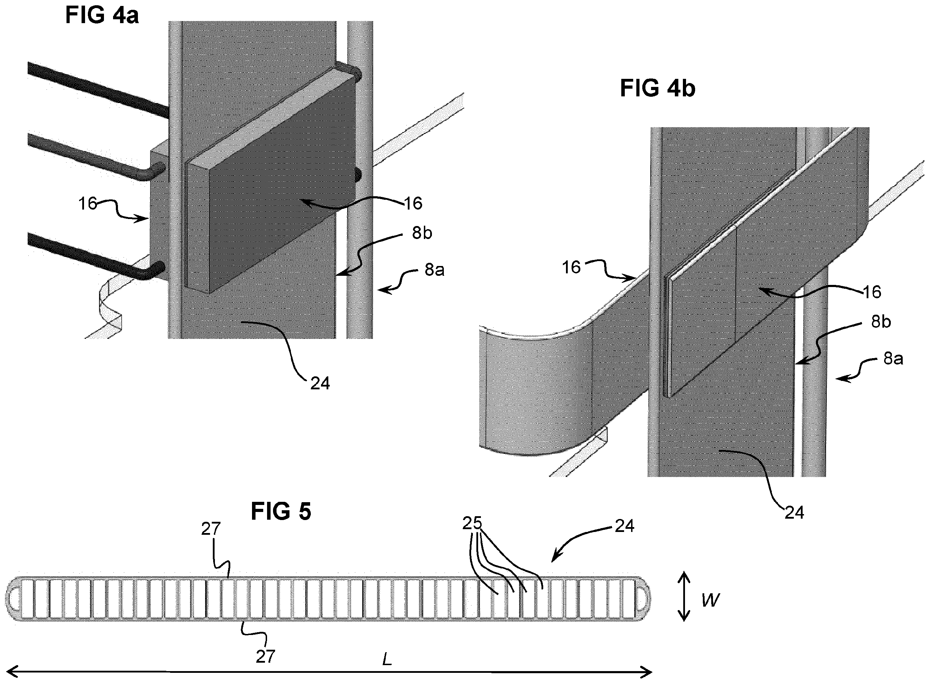

The riser 8b includes a riser pipe 24 that may have one or a plurality of channels 25 in which the coolant fluid circulates. Preferably, the riser pipe has a multi-channel configuration and for instance a substantially flat cross-section with opposed major surfaces 27 as illustrated in figures 4a, 4b, 5 in order to have a high heat exchange surface with the surface 16 of the unit cooling system 6. The channels 25 within the riser pipe 24 may have a ribbed surface in order to increase the surface area and heat exchange with the coolant fluid flowing in the riser pipe.

The riser has a plurality of evaporator sections that may simply be sections of the riser pipe against which thermal interface couplings 16 may be mounted for transferring heat from the unit cooling system 6 to the riser pipe 24.

The downcomer 8a comprises a downcomer pipe that may have the same but may have a different shape from the riser pipe and may also comprise a single channel instead of multiple channels.

In a preferred embodiment, the downcomer is not coupled thermally to individual unit cooling systems 6 and simply serves as a return line for supplying cooling fluid to the riser 8b.

The riser pipe may advantageously comprise an extruded metal construction, for instance extruded aluminum.

The riser pipe may advantageously have a substantially rectangular shape with opposed flat major outer surfaces 27 for clamping plates thereagainst that serve as a thermal interface coupling 16. The riser pipe rectangular cross-sectional profile preferably has a length *L* to width *W* ratio *L*/*W* in a range of 3/1 to 30/1 and preferably in a range of 4/1 to 20/1. These proportions provide an optimum compromise between structure rigidity, manufacturability, minimum flow resistance, and heat exchange surface area available for attaching the unit cooling system 6.

The riser pipe may have a substantially linear geometry from the top to the bottom of the stack such that the unit cooling systems 6 may be coupled there along at any position vertically with respect to the riser pipe without special considerations.

Each unit cooling system 6 comprises a fluid flow circuit 13 in which a coolant or possibly a plurality of coolants flow configured as a LTS or PHP cooling system. For the LTS, the fluid flow circuit 13 comprises an evaporator line (or pipe) 14a that is connected as an input to a thermal interface coupling 16 thermally coupled to the riser 8b of the stack cooling system 4, and as an output to a thermal interface coupling 15 thermally coupled to a heat generating component 5 of the electronic unit 3, for instance a processor thereof. The fluid flow circuit 13 also comprises a condenser line (or pipe) 14b that is connected as an output to the thermal interface coupling 16 thermally coupled to the riser 8b of the stack cooling system 4, and that is connected as an input to the thermal interface coupling 15 thermally coupled to the heat generating component 5 of the electronic unit 3. Each unit cooling system 6 can be attached to one or more heat generating components 5, here illustrated with two heat generating components. The housing 7 may be horizontal, or in other commonly used orientation, as long as the elevation of the condenser thermal interface coupling 16 is above that of the evaporator thermal interface coupling 15.

In an advantageous embodiment for the PHP, illustrated in figures 2b, 4b and 6 to 6b, the fluid flow circuit comprises a multi-channel pipe 34 with end pieces 38 having therein a plurality of channels 36 forming a serpentine circuit for PHP cooling. The condenser end thermal interface coupling 16 of the multi-channel pipe 34 is clamped against a major surface 27 of the riser 8b. The unit cooling system 6 may comprise a second multi-channel pipe 34 having a thermal interface coupling 16 clamped to an opposing side 27 of the riser pipe, for instance as illustrated in figure 4b. The two multi-channel pipes 34 in figure 2b may be replaced by a single multi-channel pipe 34 for connecting two heat generating components 5 to the condenser end thermal interface coupling 16 to a major surface 27 of the riser 8b. Further fluid flow circuit pipes coupled to heat generating components in the electronic unit may be provided as part of the unit cooling system 6 in which case the condenser end thermal interface coupling 16 of both pipes may be clamped to the riser 8b just above or just below the condenser section of other fluid flow circuits of the unit cooling system 6. The housing 7 may be horizontal, or in other commonly used orientation.

The use of PHP or LTS cooling systems within each electronic unit 3 that are separate fluid circuits from the principal cooling system 4 of the stack (the stack cooling system 4) yet thermally coupled thereto along the riser 8b, provide a very flexible arrangement in which individual electronic units can be decoupled and coupled to the multi-unit electronic apparatus stack 1 and the associated stack cooling system 4 without interfering with the other electronic units. Moreover a fault in the cooling circuit of one of the unit cooling system 6 affects only a single electronic unit and thus the overall reliability and safety of the cooling system is improved.

The use of PHP and LTS cooling circuits in both the individual electronic units and the stack of electronic units provide a very compact cooling arrangement with a high power heat transfer per unit volume while yet a flexible, easy to install and reliable arrangement.

### List of references

Multi-unit electronic apparatus stack (e.g. server rack) 1
   Electronic unit (e.g. server) 3
   Electronic components 5
   Housing 7
Cooling system 2
   Stack cooling system 4
   Coolant
   Fluid flow circuit 8
      Downcomer 8a
      Riser 8b
         Riser pipe / tube 24
         Channels 25
         Opposed major surfaces 27
   ***Unit thermal interface coupling 16***
   ***Principal condenser 12***
      Heat exchanger
      Liquid-liquid heat exchanger 26a
         Heat exchanger block 29
         Hot liquid circuit 30a
            Channels 25a
         Cool liquid circuit 30b
            Channels 25b
      (Overhead) Air-liquid heat exchanger 26b
         Fluid circuit
         Ventilator 32
         Overhead loop thermosyphon 33
***Unit cooling system 6***
   Coolant
   Fluid flow circuit 13
      LTS piping 14a, 14b
         Condenser line (pipe) 14a
         Evaporator line (pipe) 14b
      PHP piping / tube 34
         Channels 36
         Endpiece 38
   Condenser end (unit) thermal interface coupling 16 Evaporator end thermal interface coupling 15

## Claims

1. Cooling system for a multi-unit electronic apparatus stack (1) comprising a plurality of stacked electronic units (3), the cooling system comprising a plurality of unit cooling systems (6) incorporated in, on or between each electronic unit, each unit cooling system (6) comprising one or more fluid flow circuits (13) configured as:
- a pulsating heat pipe (PHP) including a pipe (34) having one or more channels (36) therein containing a coolant fluid, the pipe (34) extending between a condenser end (16) and an evaporator end (15), or
- a thermosyphon (LTS) cooling system comprising pipes (14a, 14b) extending between a condenser end (16) and an evaporator end (15);
the cooling system (2) further comprising a stack cooling system (4) comprising a principal condenser (12) and a fluid flow circuit (8) including a downcomer (8a) and a riser (8b) configured as a loop thermosyphon (LTS) cooling system, the riser comprising a riser pipe (24) extending vertically across a plurality of stacked electronic units (3), each of the unit cooling systems (6) comprising a thermal interface coupling (16) thermally coupled to the riser pipe (24), the fluid flow circuits (13) of the unit cooling systems being independent from the fluid flow circuit (8) of the stack cooling system (4).

2. Cooling system according to the claim 1 wherein the riser pipe comprises a rectangular cross-section.

3. Cooling system according to the preceding claim wherein the riser pipe cross-section has a length *L* to width *W* ratio *L*/*W* in a range of 30/1 to 3/1.

4. Cooling system according to either of the two directly preceding claims wherein the riser pipe has substantially flat opposed surfaces (27) and the thermal interface coupling (16) comprises a flat surface for clamping against the flat surface of the riser pipe.

5. Cooling system according to any of the preceding claims wherein the pipe (34) of the unit cooling system (6) comprises a plurality of channels (36).

6. Cooling system according to the preceding claim wherein the plurality of channels are arranged in a serpentine shape to form a pulsating heat pipe (PHP).

7. Cooling system according to any of the preceding claims wherein the fluid flow circuit (13) of the unit cooling system (6) comprises an evaporator end (15) having a major surface for thermally coupling against a heat generating electronic component (5) of the electronic unit (3).

8. Cooling system according to any of the preceding claims wherein the pipe (34) of the unit cooling system is formed of an extruded metal piece, for instance an extruded aluminum piece.

9. Cooling system according to any of the preceding claims wherein the downcomer (8a) of the stack cooling system (4) comprises a single channel pipe.

10. Cooling system according to any of the preceding claims wherein the principal condenser (12) is arranged above a top of the multi-unit electronic apparatus stack (1).

11. Cooling system according to any of the preceding claims wherein the principal condenser comprises an air-liquid heat exchanger (26b).

12. Cooling system according to the preceding claim wherein the principal condenser comprises a liquid-liquid heat exchanger (26a) including channels (25a) for flow of the coolant (8a) of the stack cooling system (4) and channels (25b) separate therefrom for flow of cooling liquid from the air-liquid heat exchanger (26b).

13. Cooling system according to the preceding claim wherein the channels include a plurality of alternating layers of said separate channels (25a, 25b) for flow of the coolant (8a) of the stack cooling system (4) and for flow of cooling liquid from the air-liquid heat exchanger (26b).

14. Cooling system according to any of the preceding claims wherein the riser (8b) extends substantially vertically across a plurality of electronic units configured to allow clamping of thermal interface couplings of the unit cooling system at any position along the riser pipe (24).
